Europäisches Patentamt

European Patent Office

Office européen des brevets

(19)

(11) **EP 1 006 652 A2**

(12) **EUROPEAN PATENT APPLICATION**

(43) Date of publication:
**07.06.2000 Bulletin 2000/23**

(51) Int Cl.7: **H03H 21/00**

(21) Application number: **99309224.6**

(22) Date of filing: **19.11.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **01.12.1998 US 203115**

(71) Applicant: **SIEMENS CORPORATE RESEARCH, INC.**
**Princeton, New Jersey 08540 (US)**

(72) Inventors:
• **Balan, Radu**
 **New York, NY 10021 (US)**
• **Jourjine, Alexander**
 **Princeton, NJ 08540 (US)**
• **Rosca, Justinian**
 **Monmouth Junction, NJ 08852 (US)**

(74) Representative: **Vigars, Christopher Ian et al**
 **Haseltine Lake & Co.,**
 **Imperial House,**
 **15-19 Kingsway**
 **London WC2B 6UD (GB)**

(54) **An estimator of independent sources from degenerate mixtures**

(57) A system that reconstructs independent signals (voice 1, voice 2) from degenerate mixtures estimates independent Auto Regressive (AR) processes from their sum. The system includes an identification system (20) and an estimator (22). A mixture (X) of two signals is inputted into the system and through the identifying and filtering processes, two estimates of the original signals are outputted. The identification system includes an ARMA identifier, a computation of autocovariance coefficients, an initializer and a gradient descent system. The estimator includes filtering.

FIG. 1

EP 1 006 652 A2

## Description

### Background of the Invention

Field of the Invention

The present invention relates to blind source separation problems and more particularly to estimating independent Auto Regressive (AR) processes from their sum.

Description of the Prior Art

A generic Blind Source Separation (BSS) problem is defined by the following: given $m$ measurements $x_1,..,$ , $x_m$ obtained from $n$ independent signals (sources) $s_1,...,s_n$, estimate the original signals through n estimators $s_1,...,s_n$ based on the time-series $x_1(\cdot),...,x_m(\cdot)$.

Current BSS literature addresses only the case when the number of sources is equal to the number of microphones, in example $m=n$. This is discussed by S.Amari in "Minimum Mutual Information Blind Separation", *Neural Computation,* 1996, by A.J.Bell and T.J.Sejnowski in "An Information-maximization Approach To Blind Separation And Blind Deconvolution", *Neural Computation,* 7:1129-1159, 1995, by J.F.Cardoso in "Infomax And Maximum Likelihood For Blind Source Separation", *IEEE Signal Processing Letters,* 4(4):112-114, April 1997, by P.Comon in "Independent Component Analysis, A New Concept?", *Signal Processing,* 36(3):287-314, 1994, by C.Jutten and J.Herault in "Blind Separation Of Sources, Part I: An Adaptive Algorithm Based On Neuromimetic Architecture", *Signal Processing,* 24 (1):1-10, 1991, by B.A.Pearlmutter and L.C.Parra in "A Context-sensitive Generalization Of ICA", *In International Conference on Neural Information Processing,* Hong Kong, 1996, by K.Torkkola in "Blind Separation Of Convolved Sources Based On Information Maximization", In *IEEE Workshop on Neural Networks for Signal Processing,* Kyoto, Japan 1996. The case when the number of measurements $m$ is strictly smaller than the number of sources $n$ is called the *degenerate* case.

It is desirable to reconstruct independent signals from degenerate mixtures. More specifically, it is desirable to estimate independent Auto Regressive (AR) processes from their sum.

### Summary of the Invention

An embodiment of the present invention can provide a system that reconstructs independent signals from degenerate mixtures. More specifically, an embodiment can estimate independent Auto Regressive (AR) processes from their sum. The invention addresses the identification subsystem for such a degenerate case, particularly the case of two AR processes of known finite dimension ($m$ = 1 and $n$ = 2).

An embodiment of the present invention includes an identification system and an estimator. A mixture signal and noise are inputted into the system and through noise separation, a near pure signal is outputted. The identification system includes an ARMA identifier, a computation of autocovariance coefficients, an initializer and a gradient descent system. The estimator includes filtering.

### Brief Description of the Drawings

Figure 1 illustrates an example including the present invention.

Figure 2 illustrates a block diagram of an embodiment of the present invention.

Figure 3 illustrates a block diagram of the identification system.

### Detailed Description of the Invention

An embodiment of the present invention is a system that reconstructs independent voices from degenerate mixtures by estimating independent Auto Regressive (AR) processes from their sum. The embodiment addresses the identification subsystem for such a degenerate case, particularly the case of two AR processes of known finite dimension ($m$=1 and $n$=2).

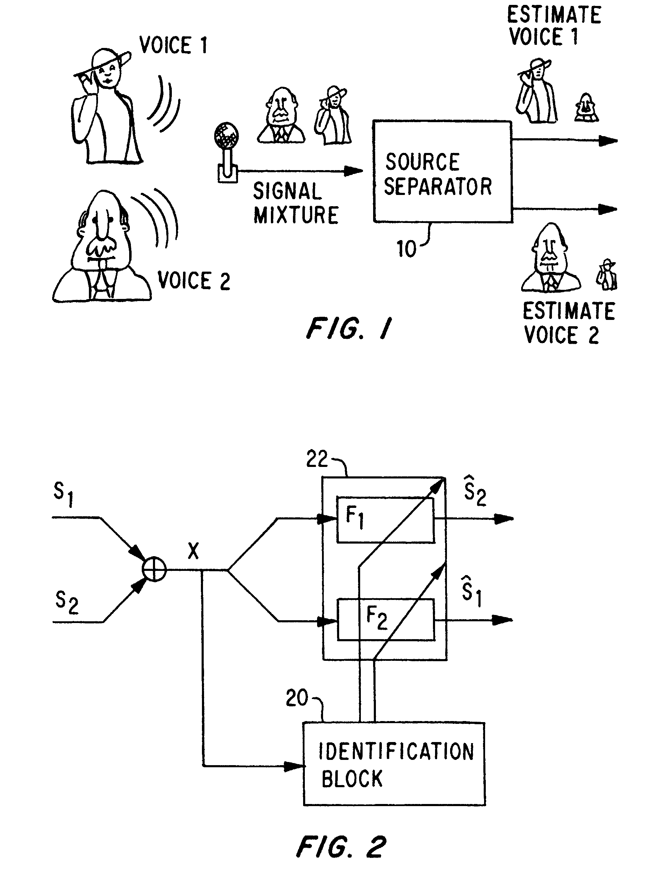

Figure 1 illustrates an example utilizing the present invention. A mixture signal, such as two voices, is inputted into the system and through source identification and filtering by source separator 10, an estimate of original sources are outputted from the present invention. The present invention estimates $n$ unknown independent components $s_1,...,$ $s_n$ (sources) from observed signals $x_1,...,x_m$ that are assumed to be linear combinations of the independent components. The present invention solves problems caused by degenerate source mixtures.

In the present invention the following assumptions are made:

1. There are two weakly stationary and independent sources $s_1$ and $s_2$ of zero mean, i.e.

$$E[s_j(k)s_j(k-n)]=E[s_j(l)s_j(l-n)], \text{ for every } k,l, j = 1,2$$

$$E[s_1(k)s_2(l)]=E[s_1(k)]=E[s_2(l)]=0 \text{ , for every } k,l \tag{1}$$

2. The source signals are obtained from two Auto Regressive (AR) ($p$) processes of order $p$ as follows:

$$s_1(n)=-a_1s_1(n-1)-a_2s_1(n-2)-...-a_ps_1(n-p)+G_1v_1(n)$$

$$s_2(n)=-b_1s_2(n-1)-b_2s_2(n-1)-...-b_ps_2(n-p)+G_2v_2(n) \tag{2}$$

where $v_1$ and $v_2$ are two independent unit variance white-noises, $a_1,...,a_p,G_1$ and $b_1,...,b_p,G_2$ are the parameters of the first, respectively the second, AR($p$) process.
3. The order $p$ is assumed known.
4. The measurement is a scalar sum of the signals:

$$x(n)=s_1(n)+s_2(n) \tag{3}$$

and is known.

As stated above, the present invention estimates the original signals. The estimators $\hat{s}_1(\cdot),\hat{s}_2(\cdot)$ that are constructed are optimal with respect to the conditional variance of the error.

The system solves the signal mixture separation problem. More specifically, a simultaneous record of two signals is given. The implementation of the system estimates each original signal. The system works best with unechoic voice signals, which can be well approximated by univariate AR processes of some order $p$.

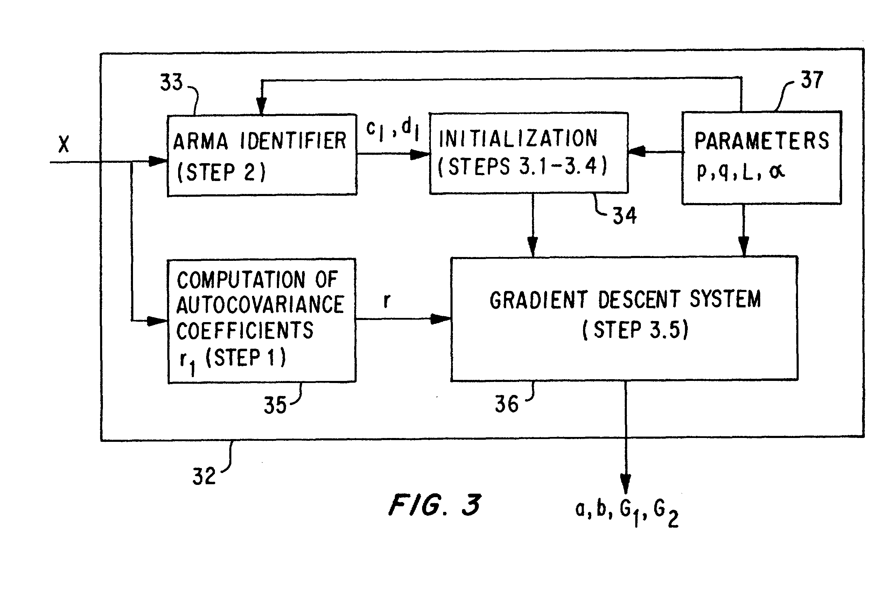

As shown in Figure 2, the major components of the embodiment are the identifier 20 and the estimator 22. There are two implementations of the present invention: an off-line implementation and an on-line implementation. Identifier 20 implements an identification system shown in Figure 3 and estimator 22, in one embodiment, is actually two Wiener filters. Identifier 20 produces an estimate of the unknown AR parameters $\hat{a}_1,...,\hat{a}_p,G_1,b_1,...,b_p,G_2$. Estimator 22 gives the minimum variance estimates based on these parameters.

As shown in Figure 3, sources s are linearly mixed in the environment. Identification system 32 receives input x from the mixing environment. Identification system 32 includes ARMA identifier 33, initializer 34, computation of autocovariance coefficients 35 and gradient descent system 36. ARMA identifier 33, initializer 34 and gradient descent system 36 receive parameters p, q, l and $\alpha$ from parameter block 37. Outputted from identification system 32 are source estimates.

ARMA identifier 33 performs the operation described by step 2 below. Computation of autocovariance coefficients 35 performs the operation described by step 1 below. Initializer 34 performs the operation described by steps 3.1 through 3.4 and the gradient descent system 36 performs the operation of step 3.5 described below.

The off-line implementation assumes the entire measured signal is known from the start. Thus $\{x(n)\}_n$ is known for $n=1,...,N$ and the method computes the estimates $\hat{s}_1(n)\}_n,\{\hat{s}_2(n)\}_n$ based on this knowledge. In the on-line implementation, at the moment $t$ only the samples $\{x(n)\}_n$ for $n=1,...,t$ are known. Based on this information, the system produces the estimates $\hat{s}_1(t+1),\hat{s}_2(t+1)$ immediately after it receives $x(t+1)$. Variations along this line are also considered. For instance the measured signal is split into time-windows of length

$$M_0, \; x_j(k)\}_{k=1,...,M_0} \; ,j = 1,..., \; \frac{N}{M_0} \; , \; x_j(k)=x(M_0j + K),$$

k=1,...,$M_0$. Then, for a given $j_0$, immediately after the moment $M_0j_0$, the system produces the estimates $\hat{s}_1((j_0-1)M_0+k)\}_{k=1,...,M_0},\{\hat{s}_2((j_0-1)M_0+k)\}_{k=1,...,M_0}$ . Thus the length $M_0$ controls the time lag between the original signals and their estimates.

Embodiments of the present invention are based on the second order statistics of the measurement characterized through the sampled autocovariance coefficients computed in the off-line implementation through

$$\hat{r}(l) = \frac{1}{N} \sum_{k=l+1}^{N} x(k)x(k-l) \qquad (4)$$

In the on-line implementation, these coefficients are estimated through (24).

In the off-line implementation, identifier 20 performs the following steps with the following inputs: $\{x(n)\}_{n=1,...,N}, P,$ and constants: $L, q, \alpha_0, ..., \alpha_L, \varepsilon$

*Step 1.* Compute $\hat{r}(l)$ for $l=0,...,L$;

*Step 2.* Identify the measured signal as an ARMA($2p,p$)process.
Thus two polynomials, one of degree $p$,

$$Q(z) = \sum_{l=0}^{p} c_l z^l \qquad (5)$$

and another of degree $2p$,

$$P(z) = 1 + \sum_{l=1}^{2p} d_l z^l \qquad (6)$$

are obtained. The zeros of $P$ define the ARMA($2p,p$) process poles.

*Step 3.* For each partition of the $2p$ poles identified at Step 2, into two admissible sets of $p$ poles repeat:

*3.1* Find $P_1$ and $P_2$ the $p^{th}$ degree polynomials whose roots
are, respectively, $p$ poles from each partition.
Set

$a_l^{(0)}, b_l^{(0)}$ $l=0,...,p$ the coefficients of $P_1, P_2$ as follows:

$$P_1(z) = 1 + \sum_{l=1}^{p} a_l^{(0)} z^l \ , \ a_0^{(0)} = 1$$

$$\qquad\qquad (7)$$

$$P_2(z) = 1 + \sum_{l=1}^{p} b_l^{(0)} z^l \ , \ b_0^{(0)} = 1$$

3.2 Solve the following linear system:

$$\begin{bmatrix} \sum_{l=-p}^{p} h_l^2 & \sum_{l=-p}^{p} h_l g_l \\ \sum_{l=-p}^{p} h_l g_l & \sum_{l=-p}^{p} g_l^2 \end{bmatrix} \cdot \begin{bmatrix} x_1 \\ x_2 \end{bmatrix} = \begin{bmatrix} \sum_{l=-p}^{p} h_l f_l \\ \sum_{l=-p}^{p} g_l f_l \end{bmatrix} \qquad (8)$$

where $f_l, g_l, h_l$ are obtained as coefficients of

$$Q(z)Q(\frac{1}{z}) = \sum_{l=-p}^{p} f_l z^l$$

$$P_1(z)P_1(\frac{1}{z}) = \sum_{l=-p}^{p} g_l z^l \qquad (9)$$

$$P_2(z)P_2(\frac{1}{z}) = \sum_{l=-p}^{p} h_l z^l$$

*3.3* If $x_1 <0$ or $x_2 <0$ then this partition is not suitable and therefore move to the next partition. Go to Step 3.

*3.4* Set

$$G_1^{(0)} = \sqrt{x_1} \; , \; G_2^{(0)} = \sqrt{x_2} \qquad (10)$$

*3.5* Using the gradient descent algorithm minimize the following criterion:

$$J(G_1,G_2,a,b,p,L,\alpha,\hat{r},q) = \sum_{l=0}^{L} \alpha_l |a*b*\hat{r}(l) - \sum_{k=l}^{p}(G_1 b_k \Psi_1(k-l) + G_2 a_k \Psi_2(k-l))|^q$$

$$(11)$$

where $\Psi_1(l),\Psi_2(l)$, $l=0,...,p$ are obtained from the following triangular linear system,

$$\sum_{j=0}^{l} a_j \Psi_1(l-j) = G_1 \delta_{l,0} \; , \; l = 0,...,p$$

$$(12)$$

$$\sum_{j=0}^{l} b_j \Psi_2(l-j) = G_2 \delta_{l,0} \; , \; l = 0,...,p$$

with

$$a_0 = b_0 = 0$$

$$a*b*\hat{r}(l) = \sum_{k=0}^{2p}\sum_{j=0}^{k} a_j b_{k-j} \hat{r}(l-k) \qquad (13)$$

$\alpha_l$, $l = 0,...,L$, are fixed positive weights and $L,q$ are parameters.

Practically, the gradient descent step is performed as follows:

*3.5.1* Set $m = 0$ and compute

$$J^{(old)} = J(\, G_1^{(m)}, G_2^{(m)}, a^{(m)}, b^{(m)}, p, L, \alpha, \hat{r}, q\,) \qquad (8)$$

*3.5.2* Evaluate the gradient of $J$ at $G_1^{(m)}$, $G_2^{(m)}$, $a^{(m)}$, $b^{(m)}$
in

$$Da^{(m)} = \nabla_a J(G_1^{(m)}, G_2^{(m)}, a^{(m)}, b^{(m)}, p, L, \alpha, \hat{r}, q)$$

$$Db^{(m)} = \nabla_b J(G_1^{(m)}, G_2^{(m)}, a^{(m)}, b^{(m)}, p, L, \alpha, \hat{r}, q)$$

$$DG_1^{(m)} = \frac{\partial J}{\partial G_1}(G_1^{(m)}, G_2^{(m)}, a^{(m)}, b^{(m)}, p, L, \alpha, \hat{r}, q) \qquad (9)$$

$$DG_2^{(m)} = \frac{\partial J}{\partial G_2}(G_1^{(m)}, G_2^{(m)}, a^{(m)}, b^{(m)}, p, L, \alpha, \hat{r}, q)$$

*3.5.3* Set *t*=1 and repeat

$$ax = a^{(m)} - t \cdot Da^{(m)}$$

$$bx = b^{(m)} - t \cdot Db^{(m)}$$

$$Gx_1 = G_1^{(m)} - t \cdot DG_1^{(m)}$$

$$Gx_2 = G_2^{(m)} - t \cdot DG_2^{(m)} \qquad (16)$$

$$J_x = J(Gx_1, Gx_2, ax, bx, p, L, \alpha, \hat{r}, q)$$

$$t = t/2$$

until $J_x < J^{(old)}$

*3.5.4* Set

$$a^{(m+1)} = a^{(m)} - 2tDa^{(m)}$$

$$b^{(m+1)} = b^{(m)} - 2tDb^{(m)}$$

$$G_1^{(m+1)} = G_1^{(m)} - 2tDG_1^{(m)} \qquad (17)$$

$$G_2^{(m+1)} = G_2^{(m)} - 2tDG_2^{(m)}$$

$$J^{(new)} = J_x$$

*3.5.5* If $(J^{(old)} - J^{(new)})/J^{(old)} > \varepsilon$ set

$$m = m + 1$$

$$J^{(old)} = J^{(new)} \qquad (18)$$

and go to 3.5.2.

Else set

6

$$a^{(partition)} = a^{(m+1)}$$

$$b^{(partition)} = b^{(m+1)}$$

$$G_1^{(partition)} = G_1^{(m+1)}$$

$$G_2^{(partition)} = G_2^{(m+1)} \qquad (19)$$

$$J_{opt}(partition) = J^{(new)}$$

*Step 4.* Choose the partition that gives the smallest criterion, i.e.

$$optim\_partition = \arg \min_{partition} J_{opt}(partition) \qquad (20)$$

Set:

$$\hat{a} = a^{optim\_partition}$$

$$\hat{b} = b^{optim\_partition}$$

$$\hat{G}_1 = G_1^{optim\_partition} \qquad (21)$$

$$\hat{G}_2 = G_2^{optim\_partition}$$

**Outputs:** $\hat{a}$, $\hat{b}$, $\hat{G}_1$, $\hat{G}_2$.

This identification procedure uses a number of parameters. Experimentally, the following values work well:

$$L = 3p$$

$$q = 2$$

$$\alpha_l = 1 \ , \ l = 0,...,L \qquad (22)$$

$$\varepsilon = 10^{-3}$$

For the purposes of the Step 3, a set of complex numbers is said admissible if it is invariant under the complex conjugation operator, i.e. if $z$ is in the set then $\bar{z}$ should belong to the set too.

Once the identification procedure has been done, the next step is the linear filtering of the signal $x$ performed in estimator 20 of Figure 2. The following will describe the off-line filtering block of estimator 20. The present invention uses Wiener filters to estimate $\hat{s}_1$ and $\hat{s}_2$. The Wiener filters are the minimum variance linear estimators and have been widely used in the literature as noise reduction filters. For the AR sources estimation, the filters are defined through the following relations:

$$H_1(z) = \frac{G_1^2 \hat{P}_2(z)\hat{P}_2\left(\frac{1}{z}\right)}{\hat{G}_1^2 \hat{P}_2(z)\hat{P}_2\left(\frac{1}{z}\right) + \hat{G}_2^2 \hat{P}_1(z)\hat{P}_1\left(\frac{1}{z}\right)}$$

$$\qquad (23)$$

$$H_2(z) = \frac{G_2^2 \hat{P}_1(z)\hat{P}_1\left(\frac{1}{z}\right)}{\hat{G}_1^2 \hat{P}_2(z)\hat{P}_2\left(\frac{1}{z}\right) + \hat{G}_2^2 \hat{P}_1(z)\hat{P}_1\left(\frac{1}{z}\right)}$$

where

$$\hat{P}_1(z) = 1 + \sum_{i=1}^{P} \hat{a}_i z^i, \quad \hat{P}_2(z) = 1 + \sum_{i=1}^{P} \hat{b}_i z^i .$$

Since (23) defines non-causal filters, the algorithm uses a forward-backward implementation for each filter, based on the spectral factorization theorem.

The following will describe the on-line implementation and the on-line identification algorithm. For the on-line problem, the present invention uses an adapting mechanism of the identification procedure. Suppose the estimates $\hat{a}^{(m)}, b^{(m)}, G_1^{(m)}, G_2^{(m)}$ of the parameters $a, b, G_1$ and $G_2$ based on the first $m$ samples are given and the $m+1^{st}$ sample $x$ $(m+1)$ is known. The on-line algorithm describes how these estimates are adapted.

**Input**: $\hat{a}^{(m)}, b(m), G_1^{(m)}, G_2^{(m)}, r^{(m)}(l)$ and $x(m+1)$

*Step 1.* Update the autocovariance coefficients using an exponential-window,

$$\hat{r}^{(m+1)}(l) = (1-w)\,\hat{r}^{(m)}(l) + wx(m+1)x(m+1-l), \quad l = 0,\dots,L \qquad (24)$$

*Step 2.* Perform one gradient descent step 3.5 from the off-line algorithm using the updated values of the autocovariance coefficients:

$$t^* = \arg \min_{t=2^{-n}} J(G_1^{(m)} - t \cdot DG_1, G_2^{(m)} - t \cdot DG_2, a^{(m)} - t \cdot Da, B^{(m)} - t \cdot Db, p, L, \alpha, \hat{r}^{(m+1)}, q)$$

$$(25)$$

Update the new estimates:

$$a^{(m+1)} = a^{(m)} - t^* Da$$
$$b^{(m+1)} = b^{(m)} - t^* Db$$
$$G_1^{(m+1)} = G_1^{(m)} - t^* DG_1$$
$$G_2^{(m+1)} = G_2^{(m)} - t^* DG_2$$

$$\qquad (26)$$

*Step 3.* Set $m=m+1$ and go to Step 1.

**Outputs:** $\hat{a}^{(m+1)}, b^{(m+1)}, G_1^{(m+1)}, G_2^{(m+1)}, \hat{r}^{(m+1)}(l)$

The parameter $w$ at Step 1 represents the adapting rate of the algorithm. Usually it is taken very close to 0.

The following will describe on-line filtering. The filtering block adapts its parameters (through (23) at every $M_0$ samples. Depending on the application, either a forward-backward implementation is used (if the processes are slow), or the forward filtering part only is used (if the processes are fast). In the latter case, the forward filter is the causal (i. e. stable) part of (23).

The present invention solves problems caused by degenerate source mixtures. The present invention can be utilized in any application requiring speech enhancement and noise reduction such as hearing aids, mobile phones, stationary phones and speech recognition and detection systems. The present invention also has applications with source separation in EKG, EEG, magneto-encephalograms and fetal monitoring.

It is not intended that this invention be limited to the hardware or software arrangement or operational procedures shown disclosed. This invention includes all of the alterations and variations thereto.

## Claims

1. An estimator of independent sources from degenerate mixtures comprising:

   an identification system for receiving said degenerate mixtures; and
   an estimator filter connected to said identification system.

2. An estimator of independent sources from degenerate mixtures as claimed in claim 1 wherein said identification system comprises:

   an ARMA identifier
   a computation of autocovariance coefficients connected to said ARMA identifier
   an initializer connected to said ARMA identifier; and
   a gradient descent system connected to said initializer and said computation of autocovariance coefficients.

FIG. 1

FIG. 2

FIG. 3

EP 1 006 652 A2